## Europäisches Patentamt
## European Patent Office
## Office européen des brevets

(11) Veröffentlichungsnummer: **0 004 293**
**B1**

(12) **EUROPÄISCHE PATENTSCHRIFT**

(45) Veröffentlichungstag der Patentschrift: **30.09.81**

(21) Anmeldenummer: **79100578.8**

(22) Anmeldetag: **26.02.79**

(51) Int. Cl.³: **H 01 L 25/04,**
**H 01 L 25/10,//H 01 L 23/36**

(54) Anordnung von Scheibenthyristoren in thermischer und elektrischer Kontaktierung auf Kühlkörpern.

(30) Priorität: **23.03.78 DE 2812699**

(43) Veröffentlichungstag der Anmeldung:
**03.10.79 Patentblatt 79/20**

(45) Bekanntmachung des Hinweises auf die Patenterteilung:
**30.09.81 Patentblatt 81/39**

(84) Benannte Vertragsstaaten:
**FR GB IT SE**

(56) Entgegenhaltungen:
**DE - A - 2 611 260**
**DE - A - 2 639 979**

(73) Patentinhaber: **BROWN, BOVERI & CIE**
**Aktiengesellschaft Mannheim**
**Kallstadter Strasse 1**
**D-6800 Mannheim Käfertal (DE)**

(72) Erfinder: **Amelunxen, Bernd**
**Schwalbenstrasse 26**
**D-6840 Lampertheim (DE)**

(74) Vertreter: **Kempe, Wolfgang, Dr., et al**
**c/o Brown, Boveri & Cie AG**
**Postfach 351**
**D-6800 Mannheim 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Anordnung von Scheibenthyristoren in thermischer und elektrischer Kontaktierung auf Kühlkörpern

Die Erfindung bezieht sich auf eine Anordnung von Scheibenthyristoren in thermischer und elektrischer Kontaktierung auf Kühlkörpern für die Anwendung in zwei- oder mehrphasigen antiparallelen Brückenschaltungen, wobei in einem Stromrichter mehrere Kühlkörper neben- oder übereinander angeordnet sind und ein Kühlkörper zur Kühlung von mindestens zwei Thyristoren dient. Sie kann Anwendung finden bei einem Umkehrstromrichter in kreisstromfreier antiparalleler Brückenschaltung.

Unter "Scheibenthyristoren" werden anschlußfertige, scheibenförmige, randseitig mit Isoliergehäuse versehene, an ihren zur Scheibenebene parallelen Hauptoberflächen, der Anoden- und der Kathodenseite mit äußeren Anschlüssen kontaktierbare, vorzugsweise elektrisch und thermisch druckkontaktierbare, steuerbare Leistungs-Halbleiterbauelemente verstanden (BBC-Druckschrift Nr. D HS 70467 D (1977), "Kühlung und Montage von Leistungshalbleiterbauelementen", Titelseite und Seiten 5, 21 bis 28). Aus dieser Druckschrift ist es bekannt, mehrere Bauelemente mit gleichnamigen Hauptelektroden auf einen gemeinsamen Kühlkörper zu montieren.

Es sind weiterhin Moduln aus jeweils zwei antiparallelen Thyristoren bekannt, die zum Aufbau von mehrphasigen antiparallelen Brückenschaltungen dienen können (Prospekt "Power Semiconductors" vom März 1974 der Fa. AEI Semiconductors, Seite 49: DE-OS 23 37 694). Im erstgenannten bekannten Fall besitzen für sich gehäuselose Halbleiterbauelemente ein gemeinsames quaderförmiges Kunststoffgehäuse, aus dem alle Anschlüsse nach einer einzigen Seite herausgeführt sind. Auch im zweitgenannten bekannten Fall handelt es sich nicht um Scheibenthyristoren, außerdem sind beide Thyristoren kühlkörperseitig elektrisch voneinander isoliert (Isolierabstand) und der Kühlkörper ist durch Oxidkeramik gegen beide elektrisch isoliert.

Es bietet sich wie im eingangs genannten bekannten Fall für mehrere Bauelemente als vorteilhaft an, beim Aufbau von zwei- oder mehrphasigen antiparallelen Stromrichter-Schaltungen mit Gleichstromausgang und mit relativ großer Einschaltdauer der einen oder anderen Stromrichtung jeweils zwei antiparallel wirksame Thyristoren, von denen nur der eine von beiden einen Strom führt, während der andere stromlos ist, auf einem Kühlkörper anzuordnen, der in seinem Kühlvermögen nur für die Verlustleistung eines Thyristors bemessen ist. In den häufig benutzten gegenparallelen Brückenschaltungen würde diese Anordnung die Verwendung von zwei Kühlkörpern je Wechselstromanschluß erfordern.

Der Erfindung liegt, ausgehend von der Anordnung der eingangs beschriebenen Art, die Aufgabe zugrunde, den Kühlkörperaufwand zu reduzieren.

Die Lösung dieser Aufgabe besteht darin, daß erfindungsgemäß mit jedem Wechselstromanschluß ein Kühlkörper mit vier Scheibenthyristoren verbunden ist, der in seinem Kühlvermögen für die Verlustleistung von zwei Scheibenthyristoren dimensioniert ist und daß der Kühlkörper von zwei Thyristoren mit ihrer jeweiligen Anodenseite und zwei Thyristoren mit ihrer jeweiligen Kathodenseite kontaktiert ist.

Die damit erreichte Einsparung von einem Kühlkörper je Wechselstromanschluß läßt sich durch den Einsatz von Scheibenthyristoren besonders einfach realisieren, weil diese sowohl anodenseitig als auch kathodenseitig wegen ebener Anschlußflächen problemlos kontaktierbar sind, z.B. durch eine mit Kühlkörper einerseits und weiteren Anschlußelementen wie Stromschienen andererseits zusammenwirkende an sich bekannte Spannvorrichtung (BBC-Druckschrift s.o.) druckkontaktiert werden können.

Bei einer Ausführungsform sind auf jedem Kühlkörper je zwei antiparallel wirksame, räumlich benachbart angeordnete Thyristoren auf ihrer dem Kühlkörper abgewandten Seite mittels eines leitenden Joches direkt kontaktiert, das mit mindestens einem weiteren solchen auf einem anderen Kühlkörper angeordneten Thyristorpaar mit gleichnamigem Anschlußpotential über eine erste Verbindungsschiene verbunden ist. Dabei wird der entsprechende Kühlkörperbereich wechselweise für die beiden benachbarten Thyristoren als Wärmesenke wirksam. Der Kühlkörper kann folglich insgesamt relativ klein bemessen sein.

Bei dieser Ausführungsform ist jede erste Verbindungsschiene mit einer quer zu ihr verlaufenden zweiten Verbindungsschiene verbunden, und die beiden zweiten Verbindungsschienen bilden die entsprechenden Gleichstromanschlüsse des Stromrichters.

Bei einer anderen Ausführungsform sind die je Kühlkörper einander entsprechenden, dem Kühlkörper abgewandten Anoden- bzw. Kathodenseiten einzelner Thyristoren auf verschiedenen Kühlkörpern durch je eine Längsschiene miteinander verbunden.

Dabei sind jeweils mindestens zwei antiparallel wirksame, unterschiedlichen Kühlkörpern zugehörige, durch benachbarte Längsschienen verbundene Thyristorgruppen durch eine quer zu ersteren verlaufende Querschiene miteinander verbunden, und diese Querschiene bildet den entsprechenden Gleichstromanschluß des Stromrichters.

Die Erfindung wird nachfolgend anhand zweier in der Zeichnung dargestellter Ausführungsbeispiele näher erläutert.

Es zeigen:

Fig. 1 eine erste Ausführungsform einer antiparallelen Brückenschaltung mit je zwei antiparallelen paarweise zusammengefaßten Thyristoren und zwei Paaren je Kühlkörper;

Fig. 2 ein Schaltbild zur Anordnung nach Fig. 1;

Fig. 3 eine zweite Ausführungsform mit jeweils view äquidistant auf einem Kühlkörper angeordneten Thyristoren, wobei drei solcher Kühlkörper vorhanden sind und

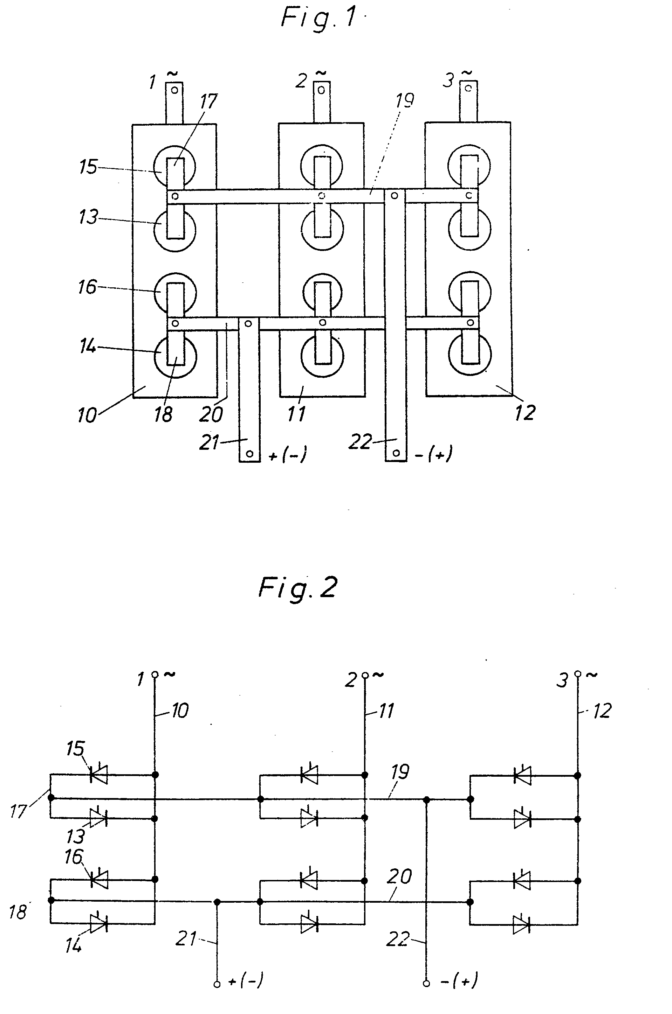

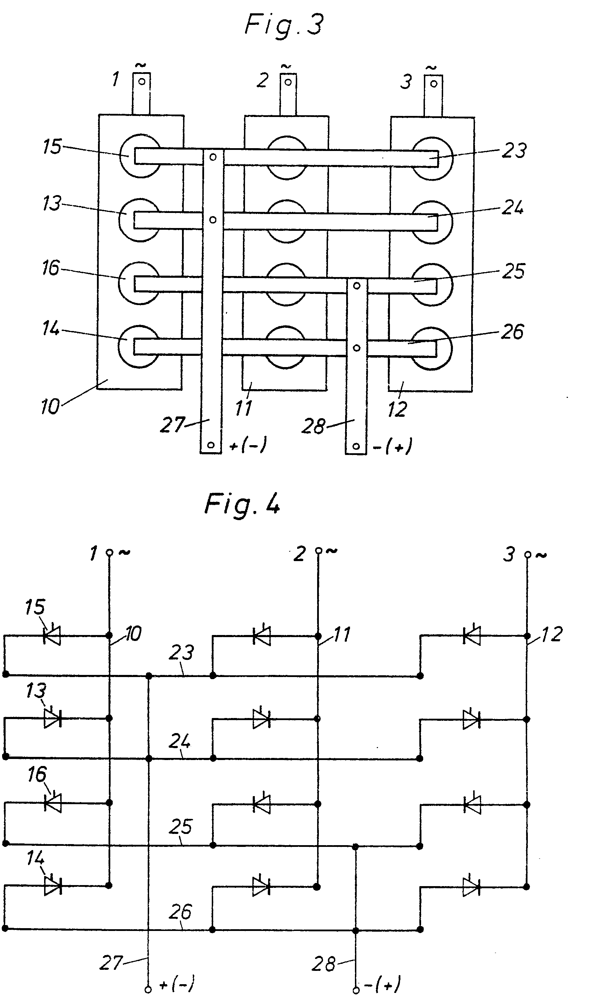

Fig. 4 ein Schaltbild zur Anordnung nach Fig. 3. Gemäß den Fig. 1 und 2 ist eine antiparallele Brückenschaltung in der Form verwirklicht, daß jedem Wechselstromanschluß 1, 2, 3 ein Kühlkörper 10, 11, 12 zugeordnet ist und je Kühlkörper 10, 11, 12 zwei Scheibenthyristoren 13, 14 mit der Kathodenseite und zwei Scheibenthyristoren 15, 16 mit der Anodenseite auf einen gemeinsamen Kühlkörper 10, 11, 12 gebracht werden. Die Kühlkörper 10 bis 12 verfügen über Wechselstromanschlüsse 1, 2, 3. Die Verbindung von jeweils einer dem Kühlkörper 10 abgewandten Anoden- und Kathodenseite jeweils zweier räumlich eng behachbarter, antiparalleler Thyristoren 13 und 15 bzw. 14 und 16 erfolgt durch eine Schiene bzw. ein Joch 17 bzw. 18.

Jeweils eine erste Verbindungsschiene 19 bzw. 20 verbindet entsprechende Thyristorpaare gleichnamigen Anschlußpotentials auf den drei Kühlkörpern 10, 11, 12. An diese ersten Verbindungsschienen 19, 20 sind quer zu diesen verlaufende zweite Verbindungsschienen 21, 22 angeschlossen, die jeweils nur eine der ersten Verbindungsschienen 19 bzw. 20 kontaktieren und die Gleichstromanschlüsse des Stromrichters bilden. In der Fig. 2 sind die entsprechenden Verbindungen wie in Fig. 1 bezeichnet, die Gleichstromanschlüsse 21, 22 haben bei Gleichrichtung die eingetragene äußere Anschlußpolarität.

Bei der Anordnung nach den Fig. 3 und 4 sind die aneinander entsprechenden Thyristoren auf verschiedenen Kühlkörpern 10, 11, 12 einzeln auf ihren von den Kühlkörpern 10, 11, 12 abgewandten Kathoden- bzw. Anodenseiten von je einer die drei Kühlkörper 10, 11, 12 überspannenden Längsschienen 23 bis 26 kontaktiert, z.B. die Thyristoren 15 kathodenseitig von der Längsschiene 23, die Thyristoren 13 anodenseitig von der Längsschiene 24 usw.. Jeweils zwei benachbarte der achsparallel laufenden Längsschienen 23 bis 26 sind durch zwei quer zu ihnen verlaufende Querschienen 27, 28 verbunden, die Längsschienen 23 und 24 durch die Querschiene 27, die Längsschiene 25 und 26 durch die Querschiene 28. Die beiden Querschienen 27, 28 bilden die Gleichstromanschlüsse des Stromrichters.

Die Anordnungen nach den Figuren 1 und 3 werden vorzugsweise mit Luft gekühlt. Die Führung der Kühlluft erfolgt in vertikaler Richtung, d.h. senkrecht zu den Scheibenebenen der Thyristoren 13 bis 16, und zwar durch Konvektion aufgrund Eigenerwärmung oder durch Zwangsbelüftung.

Die Kühlkorper 10 bis 12 können zur Wärmeabfuhr auch von einer Isolierflüssigkeit durchflossen werden.

In weiterer Ausgestaltung kann jeder Thyristoren 13 bis 16 auf seiner dem gemeinsamen Kühlkörper 10 bis 12 abgewandten Seite mit einem zusätzlichen Kühlkörper, z.B. auch mit einer flüssigkeitsdurchströmten Kühldose, bestückt sein.

## Patentansprüche

1. Anordnung von Scheibenthyristoren (13, 14, 15, 16) in thermischer und elektrischer Kontaktierung auf Kühlkörpern (10, 11, 12) für die Anwendung in zwei- oder mehrphasigen, antiparallelen Brückenschaltungen, wobei in einem Stromrichter mehrere Kühlkörper (10, 11, 12) neben- oder übereinander angeordnet sind und ein Kühlkörper zur Kühlung von mindestens zwei Thyristoren dient, dadurch gekennzeichnet, daß mit jedem Wechselstromanschluß (1, 2, 3) ein Kühlkörper (10, 11, 12) mit vier Scheibenthyristoren (13, 14, 15, 16) verbunden ist, der in seinem Kühlvermögen für die Verlustleistung von zwei Scheibenthyristoren dimensioniert ist und daß der Kühlkörper (10, 11, 12) von zwei Thyristoren (13, 14) mit ihrer jeweiligen Anodenseite und von zwei Thyristoren (15, 16) mit ihrer jeweiligen Kathodenseite kontaktiert ist.

2. Anordnung nach Anspruch 1, dadurch gekennzeichnet daß auf jedem Kühlkörper (10, 11, 12) je zwei antiparallel wirksame, räumlich benachbarte Thyristoren (13, 15, 14, 16) auf ihrer dem Kühlkörper (10, 11, 12) abgewandten Seite mittels eines leitenden Joches (17, 18) direkt kontaktiert sind, das mit mindestens einem weiteren solchen auf einem anderen Kühlkörper (10, 11, 12) angeordneten Thyristorpaar mit gleichnamigen Anschlußpotential über eine erste Verbindungsschiene (19, 20) verbunden ist.

3. Anordnung nach Anspruch 1 und 2, dadurch gekennzeichnet, daß jede erste Verbindungsschiene (19, 20) mit einer quer zu ihr verlaufenden zweiten Verbindungsschiene (21, 22) verbunden ist und die beiden zweiten Verbindungsschienen (21, 22) die Gleichstromanschlüsse des Stromrichters bilden.

4. Anordnung nach Anspruch 1, dadurch gekennzeichnet, daß die je Kühlkörper (10, 11, 12) einander entsprechenden, dem Kühlkörper abgewandten Anoden- bzw. Kathodenseiten einzelner Thyristoren (13 bis 16) auf verschiedenen Kühlkörpern (10, 11, 12) durch je eine Längsschiene (23 bis 26) miteinander verbunden sind.

5. Anordnung nach Anspruch 4, dadurch gekennzeichnet, daß jeweils mindestens zwei antiparallel wirksame unterschiedlichen Kühlkörpern (10, 11, 12) zugehörige, durch benachbarte Längsschienen (23 bis 26) verbundene Thyristor-gruppen durch eine quer zu ersteren verlaufenden Querschiene (27, 28) miteinander verbunden sind und diese Querschiene (27, 28) den entsprechenden Gleichstromanschluß des Stromrichters bilden.

**Revendications**

1. Dispositif de thyristors en forme de disques (13, 14, 15, 16) placés en contact thermique et électrique sur des éléments de refroidissement (10, 11, 12), pour son utilisation dans des circuits en pont antiparallèles biphasés ou polyphasés, dans lequel plusieurs éléments de refroidissement (10, 11, 12) sont disposés côté à côté ou les uns au-dessus des autres dans un convertisseur de courant et dans lequel un élément de refroidissement sert à réaliser le refroidissement d'au moins deux thyristors, caractérisé en ce qu'à chaque borne à courant alternatif (1, 2, 3) est relié un élément de refroidissement (10, 11, 12) comportant quatre thyristors en forme de disque (13, 14, 15, 16) et dont la capacité de refroidissement est dimensionnée pour la puissance dissipée de deux thyristors en forme de disques, et que l'élément de refroidissement (10, 11, 12) est contacté par deux thyristors (13, 14) par leur côté respectif portant l'anode, et par deux thyristors (15, 16) par leur côté respectif portant la cathode.

2. Dispositif selon la revendication 1, caractérisé en ce que sur chaque élément de refroidissement (10, 11, 12), deux thyristors respectifs (13, 15; 14, 16) voisins dans l'espace et agissant à la manière d'un montage antiparallèle sont contactés directement sur leur côté tourné à l'opposé de l'élément de refroidissement (10, 11, 12), au moyen d'une culasse conductrice (17, 18) qui est reliée à au moins un autre couple de thyristors de ce type disposé sur un autre élément de refroidissement (10, 11, 12) et possédant un potentiel similaire de raccordement, par l'intermédiaire d'un premier rail de jonction (19, 20).

3. Dispositif selon les revendications 1 et 2, caractérisé en ce que chaque premier rail de jonction (19, 20) est relié à un second rail de jonction (21, 22) s'étendant transversalement par rapport audit premier rail et que les deux seconds rails de jonction (21, 22) constituent les bornes à courant continu du convertisseur de courant.

4. Dispositif selon la revendication 1, caractérisé en ce que les faces respectives portant les anodes et les cathodes, se correspondant entre elles pour chaque élément de refroidissement (10, 11, 12) et tournées à l'opposé de l'élément de refroidissement, de thyristors individuels (13 à 16) situés sur différentes éléments de refroidissement (10, 11, 12) sont reliées entre elles par des rails longitudinaux respectifs (23 à 26).

5. Dispositif selon la revendication 4, caractérisé en ce qu'au moins deux groupes de thyristors agissant à la façon d'un montage antiparallèle, associés à différents éléments de refroidissement (10, 11, 12) et reliés par des rails longitudinaux voisins (23 à 26), sont reliés entre eux par des rails transversaux respectifs (27, 28) s'étendant transversalement par rapport auxdits premiers rails et que ces rails transversaux (27, 28) forment la borne correspondante à courant continu du convertisseur de courant.

**Claims**

1. Arrangement of disc thyristors (13, 14, 15, 16) in thermal and electrical contact on heat sinks (10, 11, 12) for use in two- or multiphase, antiparallel bridge circuits, a plurality of heat sinks (10, 11, 12) being arranged side by side or one above the other in a convertor and one heat sink serving to cool at least two thyristors, characterised in that a heat sink (10, 11, 12) with four disc thyristors (13, 14, 15, 16) is connected to each alternating current power supply (1, 2, 3) and is dimensioned as regards its cooling capacity for the power loss of two disc thyristors and in that the heat sink (10, 11, 12) is contacted by the respective anode side of two thyristors (13, 14) and by the respective cathode side of two thyristors (15, 16).

2. Arrangement according to claim 1, characterised in that, on each heat sink (10, 11, 12), two respective adjacent thyristors (13, 15; 14, 16), which act in an antiparallel manner, are directly contacted on their side remote from the heat sink (10, 11, 12) by means of a conducting yoke (17, 18) which is connected to at least one further such pair of thyristors, arranged on another heat sink (10, 11, 12) and with like connection potentials, via a first connection bar (19, 20).

3. Arrangement according to claims 1 and 2, characterised in that each first connection bar (19, 20) is connected to a second connection bar (21, 22) extending transversely to the first connection bar and the two second connection bars (21, 22) form the direct current power supplies of the convertor.

4. Arrangement according to claim 1, characterised in that the anode and cathode sides — corresponding to each other on each heat sink (10, 11, 12) and remote from the heat sink — of individual thyristors (13 to 16) on different heat sinks (10, 11, 12) are connected together in each case by a longitudinal bar (23 to 26).

5. Arrangement according to claim 4, characterised in that in each case at least two thyristor groups, which act in an antiparallel manner, belong to different heat sinks (10, 11, 12) and are connected by adjacent longitudinal bars (23 to 26), are connected together by a transverse bar (27, 28) extending transversely to the first bar and these transverse bars form the corresponding direct current power supply of the convertor.

# 0 004 293

## Fig. 1

## Fig. 2

## Fig. 3

## Fig. 4